(19) Europäisches Patentamt
European Patent Office
Office européen des brevets

(11) Veröffentlichungsnummer: **0 355 366 A2**

# (12) EUROPÄISCHE PATENTANMELDUNG

(21) Anmeldenummer: **89112677.3**

(22) Anmeldetag: **11.07.89**

(51) Int. Cl.⁴: **H01L 21/318 , C23C 16/34 , C23C 16/44**

(30) Priorität: **17.08.88 DE 3827949**

(43) Veröffentlichungstag der Anmeldung: **28.02.90 Patentblatt 90/09**

(84) Benannte Vertragsstaaten: **AT CH DE FR GB IT LI NL**

(71) Anmelder: **Siemens Aktiengesellschaft**
**Wittelsbacherplatz 2**
**D-8000 München 2(DE)**

(72) Erfinder: **Treichel, Helmuth**
**Weldishofer Strasse 4**
**D-8900 Augsburg(DE)**
Erfinder: **Spindler, Oswald, Dr.**
**Lortzingstrasse 16**
**D-8011 Vaterstetten(DE)**
Erfinder: **Neureither, Bernhard**
**Weidener Strasse 5**
**D-8000 München 83(DE)**

## (54) Verfahren zur Herstellung von Siliziumbornitridschichten für integrierte Halbleiterschaltungen.

(57) Siliziumbornitridschichten, die als Intermetallisations- und/oder Endpassivierungsschichten eingesetzt werden können, werden unter Verwendung flüssiger Ausgangsverbindungen, die bereits einen Teil der Zielzusammensetzung der herzustellenden Siliziumbornitridschicht molekular enthalten, durch chemische Dampfabscheidung in einem elektromagnetischen Wechselfeld hergestellt. Die so hergestellen Siliziumbornitridschichten weisen eine Dielektrizitätskonstante $\epsilon$ auf, deren Wert kleiner als 4 $\epsilon_0$ ist und zeichnen sich durch gute Isolations- und Sperreigenschaften und eine hohe Durchbruchfestigkeit aus.

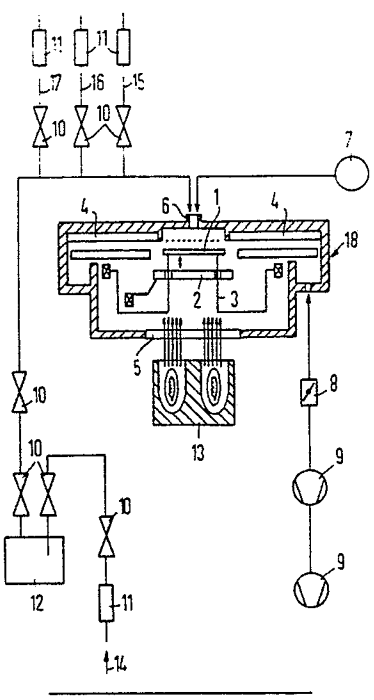

EP 0 355 366 A2

## Verfahren zur Herstellung von Siliziumbornitridschichten für integrierte Halbleiterschaltungen

Die Erfindung betrifft ein Verfahren zur Herstellung einer Siliziumbornitridschicht mit einer Dielektrizitätskonstante $\epsilon$ von kleiner als $4\epsilon_0$ durch chemische Dampfabscheidung in einem elektromagnetischen Wechselfeld.

Für Intermetallisations- und Endpassivierungsschichten für höchstintegrierte Halbleiterschaltungen werden dielektrische Schichten mit kleinen Dielektrizitätskonstanten, guten Isolations- und Sperreigenschaften und hohen Durchbruchfestigkeiten benötigt, die außerdem eine möglichst konforme Kantenbedeckung darunterliegender Schichten aufweisen sollen und nicht hygroskopisch wirken sollen.

In den letzten Jahren wurde zunehmend durch PECVD-Verfahren (Plasma Enhanced Chemical Vapor Deposition = chemische Dampfabscheidung in einem elektromagnetischen Wechselfeld) abgeschiedenes Siliziumnitrid eingesetzt, das Phosphorsilikatglas wegen seiner ungünstigen Eigenschaft der Hygroskopizität ersetzt. Damit wurden Schichten mit guten Isolationseigenschaften und hohen Sperreigenschaften gegen Feuchtigkeit und Alkaliionen erhalten. Siliziumnitridschichten zeigen außerdem eine gute Kantenbedeckung und eine hohe Durchbruchsfestigkeit. Trotz der Vorteile dieser Schichten ist ihre Dielektrizitätskonstante relativ hoch ($\epsilon = 7\epsilon_0$), verglichen mit der des Phosphorsilikatsglas oder der von Silizumoxidschichten ($\epsilon = 4\epsilon_0$). Dies bedeutet hohe parasitäre Leckströme und relativ große Verzögerungen der Übertragungszeiten zwischen einzelnen Bauelementen. Dazu sind in dem Zeitschriftartikel von M. Maeda und Y. Arita im Journal of Applied Physics, Bd. 53, 1982, S. 6852ff und in dem Zeitschriftartikel von K.M. Mar und G.M. Samuelson in Solid State Technology, Bd. 23, 1980, S.137ff ausführliche Erörterungen enthalten.

Bornitridschichten, die durch APCVD (Atmospheric Pressure Chemical Vapor Deposition) abgeschieden werden, zeigen sich chemisch inert und temperaturstabil. Sie weisen außerdem eine kleine Dielektrizitätskonstante von $\epsilon = 2{,}7$ auf. Jedoch muß eine Instabilität gegenüber atmosphärischer Feuchtigkeit, speziell in borreichen Filmen, beobachtet werden. Untersuchungen zu APCVD-Abscheidungen von Bornitridschichten sind z.B. aus dem Zeitschriftenartikel von M. Rand und J.F. Roberts im Journal of the Electrochemical Society, Bd. 115, 1968, S. 423ff und dem Zeitschriftartikel von S.B. Hyder und T.O. Yep im Journal of the Electrochemical Society, Bd. 123, 1976, S. 1721ff bekannt.

Als Ausgangssubstanz kann nach Patents Abstracts of Japan, Bd. 9, Nr. 126 E 318, 1985 das ringförmige Molekül $B_3N_3H_6$ verwendet werden, oder nach W. Schmolla und H. Hartnagel in Solid State Electronics, Bd. 26, Nr. 10,1983, S. 931 ff, das ebenfalls ringförmige Molekül $B_3N_3H_3\ (CH_3)_3$.

Zur Verbesserung der Feuchtigkeitsresistenz dieser Filme wurde von M.Maeda und T. Malino im Japanese Journal of Applied Physics, Bd. 26, No.5, 1987, S. 660-665, ein Mischnitrid aus Siliziumbornitrid (SiBN) vorgeschlagen. Dieses amorphe Siliziumbornitrid wird dabei in einem sogenannten Parallelplatten-PECVD-Reaktor mittels einer Gasmischung aus $SiH_4$, $B_2H_6$, $NH_3$ und Ar abgeschieden. Dieses Verfahren weist aufgrund der notwendigen Installation der Gaszuführungen einen komplizierten Anlagenaufbau auf, wobei die Komposition des Gasgemisches schwierig ist.

Aufgabe der Erfindung ist es daher, ein Verfahren zur Herstellung einer Siliziumbornitridschicht, die den gestellten Anforderungen gerecht wird, anzugeben. Das Verfahren soll außerdem einfach zu steuern sein und keinen komplizierten Anlagenaufbau benötigen.

Die Aufgabe wird durch ein Verfahren der eingangs genannten Art gelöst, das dadurch gekennzeichnet ist, daß entweder 1. mindestens eine flüssige, niedermolekulare Ausgangsverbindung verwendet wird, die Bor und Stickstoff enthält und mittels eines Träger gases in die Reaktorkammer eingeleitet wird, und zusätzlich mindestens eine der gasförmigen Verbindungen $SiH_4$ und $Si_2H_6$ in die Reaktorkammer eingeleitet wird, oder

2. mindestens eine flüssige, niedermolekulare Ausgangsverbindung verwendet wird, die Bor, Stickstoff und Silizium enthält und mittels eines Trägergases in die Reaktorkammer eingeleitet wird.

Weitere Ausgestaltungen und Weiterbildungen der Erfindung gehen aus den Unteransprüchen und der nachfolgend anhand von Ausführungsbeispielen gegebenen Beschreibung hervor.

Das erfindungsgemäße Verfahren, bei dem eine Siliziumbornitridschicht durch chemische Dampfabscheidung in einem elektromagnetischem Wechselfeld (PECVD) erzeugt wird, liefert einen Abscheideprozess durch oberflächenkontrollierte chemische Reaktionen, der zur Herstellung von Siliziumbornitridschichten in den engen Strukturen höchstintegrierter Schaltungen geeignet ist.

Im folgenden werden drei Ausführungsbeispiele gegeben, die mit der in der Figur gezeigten PECVD-Anlage durchführbar sind und deren Prozeßparameter in der folgenden Tabelle zusammengestellt sind.

| Prozeßparameter | Wert |
|---|---|
| Abscheidetemperatur | 300-450 ° C |
| Prozeßdruck | 0,1-1,3 kPa |
| RF-Leistung | 300-800 W |
| Elektrodenabstand | 0,3-0,6 cm |
| Trägergasfluß | 100-600 sccm $N_2$ bzw. He |
| $N_2$- bzw. $NH_3$-Menge | 0-100 sccm |
| $SiH_4$- bzw. $Si_2H_6$-Menge | 0-500 sccm |
| Verdampfertemperatur | 25-80 ° C |

Die Figur zeigt in schematischer Darstellung eine Anlage zur chemischen Dampfabscheidung in einem elektromagnetischem Wechselfeld (PECVD). In der Reaktorskammer 18 ist eine zu bearbeitende Halbleiterscheibe 1 auf einem Halbleiterscheibenlift 3 zwischen dem Gaseinlaßbereich 6 und dem Suszeptor 2 angeordnet. Die Bewegung des Halbleiterscheibenliftes 3 ist mit einem Doppelpfeil angedeutet. Zur Evakuierung der Reaktorkammer 18 sind zwei Vakuumpumpen 9 vorgesehen, die über ein Butterflyventil 8 angeschlossen sind. Zur Erzeugung des elektromagnetischen Wechselfeldes wird ein RF-Generator eingesetzt, wobei einzelne Bereiche der Reaktorkammer 18 durch Isolatoren 4 abgeschirmt sind. Die flüssigen Ausgangsverbindungen werden in einem Verdampfergefäß (Bubbler) 12 bereitgestellt, in das als Trägergas Helium oder Stickstoff zugeführt wird. Zur Regulierung der Stickstoff- und Siliziumanteile sind weitere Gaszuleitungen 15, 16, 17 für $N_2$ (z.B. aus Hohlkathodenanregung), $NH_3$ und $SiH_4/Si_2H_6$ vorgesehen. Alle Gaszuleitungen sind mit Durchflußmengenreglern 11 und Pneumatikventilen 10 versehen. Zur Einstellung der Abscheidetemperatur in der Reaktorkammer 18 sind Lampen bzw. ein Reflektormodul 13 vorgesehen, das die in der Reaktorkammer 18 befindliche Anordnung durch ein Quarzfenster 5 bestrahlt.

Ausführungsbeispiel 1

Als flüssige Ausgangsverbindung wird $B_3N_3H_6$ verwendet, z.B.

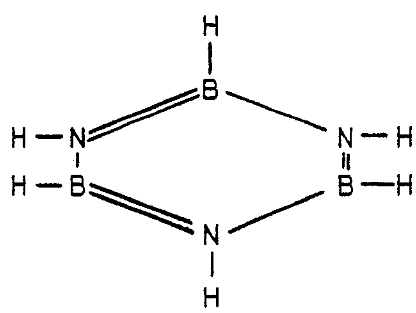

Der Siliziumanteil wird hier entweder als gasförmiges $Si_2H_6$ mit $N_2$ oder $NH_3$ zur Einstellung des Silizium-Bor-Stickstoff-Verhältnisses oder als gasförmiges $SiH_4$ zugeführt, wobei keine Zufuhr gasförmigen Stickstoffs notwendig ist.

Ausführungsbeispiel 2

Als flüssige Ausgangsverbindung wird $B_3N_3H_3\ (SiR_3)_3$ eingesetzt, wobei der Rest R Wasserstoff, $NH_2$ oder ein Alkyl ist, z.B.

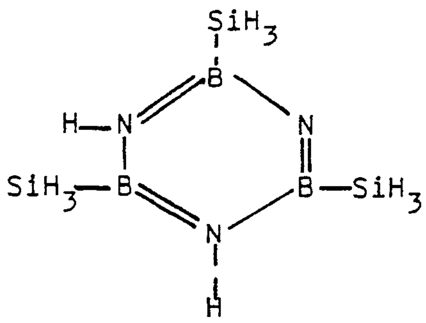

oder

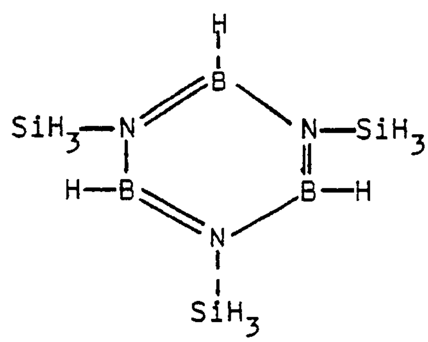

mit jeweils R=H.

Das Stickstoff-Silizium-Verhältnis wird hier durch Zugabe von $N_2$ oder $NH_3$ eingestellt. Dabei kann das Silizium-Bor-Stickstoff-Verhältnis der herzustellenden Schicht insbesondere durch geeignete Wahl der Ausgangsverbindung und Modifikation des Restes R verändert werden.

Ausführungsbeispiel 3

Als flüssige Ausgangsverbindung wird $B_3N_3$ $(SiR_3)_6$ verwendet, wobei der Rest R Wasserstoff, $NH_2$ oder ein Alkyl ist, z.B.

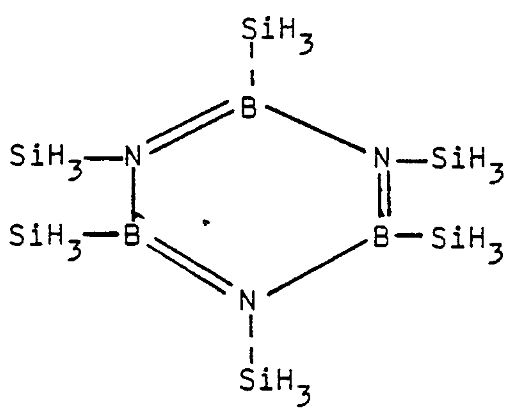

mit R=H.

Bei Verwendung eienr solchen Ausgangsverbindung, die als Rest R Wasserstoff oder ein Alkyl enthält, wird das Silizium-Stickstoff-Verhältnis durch Zufuhr von $N_2$ oder $NH_3$ eingestellt. Bei Verwendung der Ausgangsverbindung mit $NH_2$ als Rest ist keine Zufuhr gasfürmigen Stickstoffs notwendig.

Für alle Ausgestaltungen der Erfindung gilt, daß der Wert der Dielektrizitätskonstante $\epsilon$ über das Verhältnis von Silizium zu Bor und Stickstoff in der Silziumbornitridschicht verändert werden kann. In den verschiedenen, anhand von Ausführungsbeispielen beschriebenen Ausgestaltungen der Erfindung kann dieses Verhältnis durch Variation der Ausgangsverbindung, des Restes R am Silizium, der Zufuhr gasförmiger Siliziumverbindungen ($SiH_4$, $Si_2H_6$) und der Zufuhr gasförmiger Stickstoffverbindungen ($N_2$, $NH_3$) eingestellt werden. Das Silizium-Bor-Stickstoff-Verhältnis ist außerdem durch Variation der Prozeßparameter wie Abscheidetemperatur, Verdampfertemperatur, Prozeßdruck, Trägergasmenge und RF-Leistung beeinflußbar. Bei der Wahl der Prozeßparameter im Rahmen der in der Tabelle angegebenen Werte werden mit dem erfindungsgemäßen Verfahren Siliziumnitridschichten erhalten, die Dielektrizitätskonstanten aufweisen, deren Wert kleiner als 4 $\epsilon_c$ ist.

Das erfindungsgemäße Verfahren nutzt die Verwendung von flüssigen niedermolekularen Verbindungen, die sowohl Bor als auch Stickstoff (BN-Verbindungen) bzw. Bor, Stickstoff und Silizium (SiBN-Verbindungen) bereits im Molekül enthalten, d.h. die bereits einen Teil der Zielzusammensetzung der herzustellenden Siliziumbornitridschicht molekular enthalten. Das trägt dazu bei, daß die so hergestellten Siliziumbornitridschichten definierte Zusammensetzung und reproduzierbar und anhaltend gute Eigenschaften aufweisen. Die Zersetzung der Ausgangsverbindungen findet durch definierte Anregung der Moleküle in einem elektromagnetischen Wechselfeld (PECVD) statt und kann dabei durch milde thermische Anregung unterstüzt werden. Mittels des erfindungsgemäßen Verfahrens ist es möglich, Siliziumbornitridschichten bei

Temperaturen von 300° C bis 450° C herzustellen. Solche im Vergleich zu anderen Herstellungsverfahren niedrigen Temperaturen stellen eine relative Schonung der Halbleiterstrukturen dar. Neben der Verringerung der Anlagenkomplexität auf ein Minimum und der einfachen Handhabbarkeit des Verfahrens ermöglicht der Einsatz von flüssigen Ausgangsverbindungen die Reduzierung der Zahl der gefährlichen Gase (z.B. $B_2H_6$).

**Ansprüche**

1. Verfahren zur Herstellung einer Silziumbornitridschicht mit einer Dielektrizitätskonstante $\epsilon$ von kleiner als $4\epsilon_0$ durch chemische Dampfabscheidung in einem elektromagnetischen Wechselfeld,
**dadurch gekennzeichnet,** daß mindestens eine flüssige, niedermolekulare Ausgangsverbindung verwendet wird, welche Bor und Stickstoff enthält und die mittels eines Trägergases (14) in die Reaktorkammer (18) eingeleitet wird, und zusätzlich mindestens eine der gasförmigen Verbindungen $SiH_4$ und $Si_2H_6$ in die Reaktorkammer (18) geleitet wird.

2. Verfahren zur Herstellung einer Siliziumbornitridschicht mit einer Dielektrizitätskonstante $\epsilon$ kleiner als $4\epsilon_0$ durch chemische Dampfabscheidung in einem elektromagnetischen Wechselfeld, **dadurch gekennzeichnet,** daß mindestens eine flüssige, niedermolekulare Ausgangsverbindung verwendet wird, welche Bor, Stickstoff und Silizium enthält und mittels eines Trägergases (14) in die Reaktorkammer (18) eingeleitet wird.

3. Verfahren nach Anspruch 1,
**dadurch gekennzeichnet,** daß als flüssige Ausgangsverbindung $B_3N_3H_6$ verwendet wird.

4. Verfahren nach Anspruch 2,
**dadurch gekennzeichnet,** daß als flüssige Ausgangsverbindung $B_3N_3H_6$ $(SiR_3)_3$ verwendet wird, wobei als Rest Wassestoff und/oder $NH_2$ und/oder ein Alkyl eingesetzt wird.

5. Verfahren nach Anspruch 2,
**dadurch gekennzeichnet,** daß als flüssige Ausgangsverbindung $B_3N_3$ $(SiR_3)_6$ verwendet wird, wobei als Rest R Wasserstoff und/oder $ein_2$ Alkyl eingesetzt wird.

6. Verfahren nach Anspruch 2,
**dadurch gekennzeichnet,** daß als flüssige Ausgangsverbindung $B_3N_3$ $(SiR_3)_6$ eingesetzt wird, wobei als Rest R $NH_2$ eingesetzt wird.

7. Verfahren nach einem der Ansprüche 1 bis 6,
**dadurch gekennzeichnet,** daß zusätzlich mindestens eine der gasförmigen Verbindungen $N_2$ und $NH_3$ in die Reaktorkammer (18) eingeleitet wird.

8. Verfahren nach einem der Ansprüche 1 bis 7,
**dadurch gekennzeichnet,** daß als Trägergas Helium und/oder Stickstoff eingesetzt wird.

9. Verfahren nach einem der Ansprüche 1 bis 8,
**dadurch gekennzeichnet,** daß die Abscheidetemperatur 300 bis 450° C, der Prozeßdruck 0,1 bis 1,3 kPa, die RF-Leistung 300-800 W, der Elektrodenabstand 0,3 bis 0,6 cm, der Trägergasfluß 100-600 sccm, die $N_2$-und $NH_3$-Menge 0-100 sccm, die $SiH_4$- und die $Si_2H_6$-Menge 0-500 sccm und die Verdampfertemperatur 25 bis 80° C betragen.

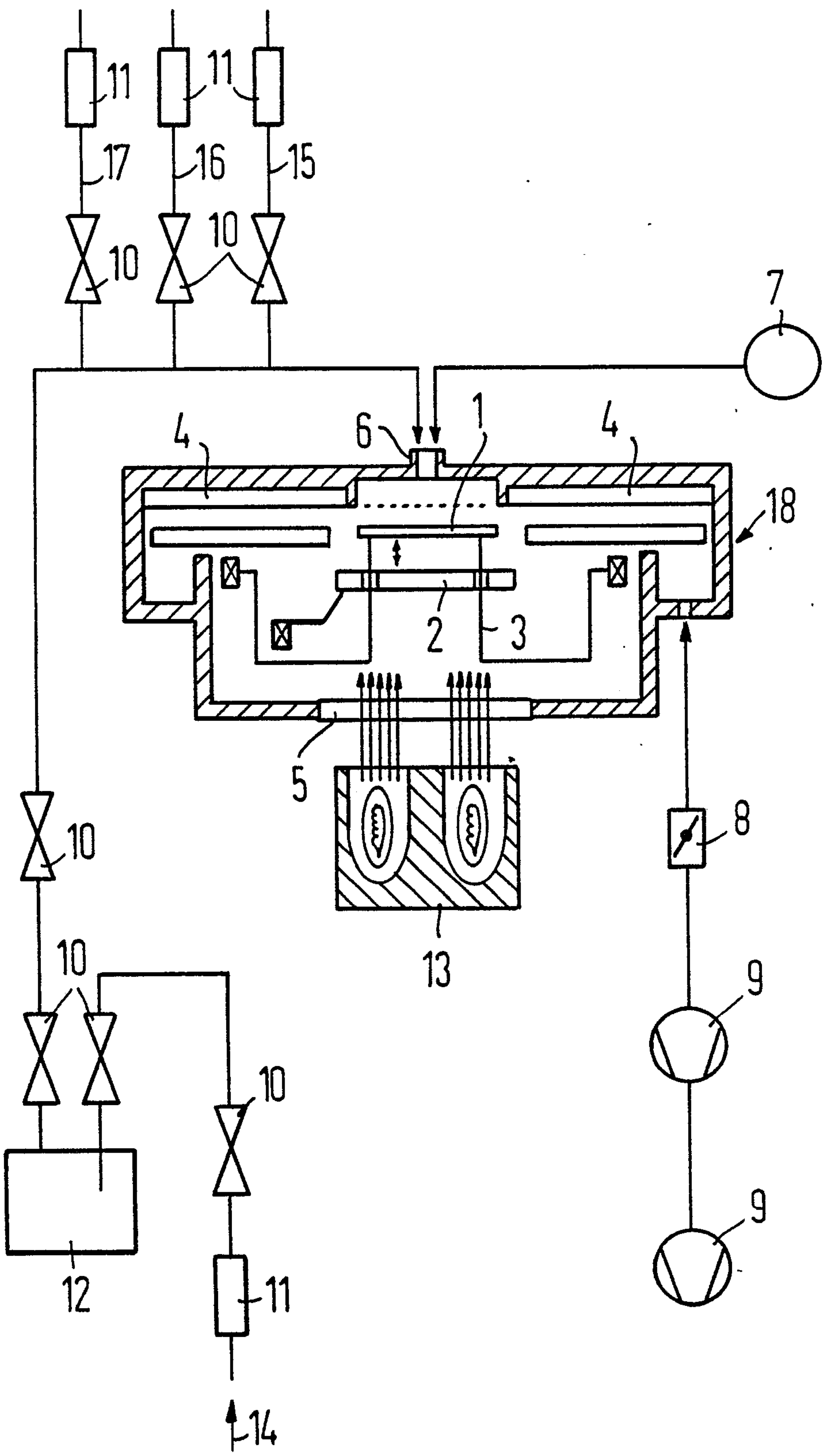
11
11
17
16
15
10
10
7
6
1
4
4
18
2
3
5
13
8
10
10
10
9
9
12
11
14